# EUROPEAN PATENT SPECIFICATION

(11) **EP 4 254 488 B1**
(45) Date of publication and mention of the grant of the patent: **01.01.2025**
(21) Application number: 23164452.7
(22) Date of filing: 27.03.2023
(51) Int. Cl.: H01L 23/373, C04B 37/02

(54) **CERAMIC SUBSTRATE AND CERAMIC DIVIDED SUBSTRATE**
KERAMISCHES SUBSTRAT UND GETEILTES KERAMISCHES SUBSTRAT
SUBSTRAT CÉRAMIQUE ET SUBSTRAT CÉRAMIQUE DIVISÉ

(30) Priority: 29.03.2022 JP 2022054655; 29.09.2022 JP 2022155898
(43) Date of publication of application: 04.10.2023
(73) Proprietor: Proterial, Ltd., Tokyo 135-0061 (JP)
(72) Inventor: OMORI, Teruyuki, Tokyo, 135-0061 (JP)
(74) Representative: Betten & Resch

(56) References cited:
- JP-A- 2004 207 587
- US-A- 6 054 762
- US-A1- 2021 028 086

## Description

### CROSS-REFERENCE TO RELATED APPLICATIONS

### TECHNICAL FIELD

The present invention relates to a ceramic substrate and a ceramic divided substrate, more particularly, a ceramic circuit board and a ceramic diced circuit board.

### BACKGROUND OF THE INVENTION

Conventionally, ceramic substrates (e.g., ceramic circuit boards) with a base (e.g. a substrate) made of highly heat-resistant ceramics are used as substrates for mounting, e.g., electrical circuit components that generate much heat, such as power modules. The ceramic circuit board described in Patent Literature 1 has a circuit plate made of a metal and brazed to the front surface, and a heat dissipation plate made of a metal and brazed to the back surface. The circuit plate is formed thicker than the heat dissipation plate and has a circuit pattern formed by etching.

### Citation List

Patent Literature 1: JP2003-309210A

### SUMMARY OF THE INVENTION

In recent years, electric motors have been widely used also as, e.g., drive sources of automobiles, and capacity of power transistors for inverters to supply drive current to electric motors is becoming increasingly higher. Ceramic substrates on which such power transistors are mounted are required to have higher heat dissipation properties than ever before. To improve heat dissipation properties, e.g., the thickness of the heat dissipation plate of the ceramic substrate could be increased to increase thermal conductivity. However, when the heat dissipation plate is made thicker than the circuit plate by simply increasing the thickness of the heat dissipation plate, warpage sometimes occurs during the manufacturing of the ceramic substrate. Also when the circuit plate is made thicker than the heat dissipation plate by increasing the thickness of the circuit plate in order to increase the current flowing to the circuit plate, warpage sometimes occurs during the manufacturing of the ceramic substrate.

Therefore, it is an object of the invention to provide a ceramic substrate and a ceramic divided substrate in which warpage can be suppressed even when one of a heat dissipation plate and a circuit plate is increased in thickness.

To solve the problem described above, one aspect of the invention provides a ceramic substrate, comprising:
a flat plate-shaped insulating base comprising a ceramic;
a first brazing material layer provided on a first main surface of the insulating base;
a second brazing material layer provided on a second main surface of the insulating base;
a circuit plate comprising a metal and being fixed through the first brazing material layer to the insulating base on a first main surface-side; and
a heat dissipation plate comprising a metal and being fixed through the second brazing material layer to the insulating base on a second main surface-side,
wherein a thickness of one of the heat dissipation plate and the circuit plate is larger than a thickness of the other,
wherein when the thickness of the heat dissipation plate is larger than the thickness of the circuit plate, a thickness of the first brazing material layer is larger than a thickness of the second brazing material layer, and
wherein when the thickness of the circuit plate is larger than the thickness of the heat dissipation plate, the thickness of the second brazing material layer is larger than the thickness of the first brazing material layer.

To solve the problem described above, the invention also provides a ceramic divided substrate that is formed by dividing the ceramic substrate described above into a plurality of pieces.

### Advantageous Effects of the Invention

According to the ceramic substrate and the ceramic divided substrate of the present invention, it is possible to suppress warpage even when one of a heat dissipation plate and a circuit plate is increased in thickness.

### BRIEF DESCRIPTION OF DRAWINGS

FIGS. 1A to 1C show a configuration example of a ceramic substrate in an embodiment of the present invention, wherein FIG. 1A is a plan view showing the front surface, FIG. 1B is a side view, and FIG. 1C is a plan view showing the back surface.
FIGS. 2A to 2C show a state in which electrical circuit components are mounted on a front surface of one of ceramic divided substrates and a heat sink as a heat dissipation component is attached to the back surface, wherein FIG. 2A is a plan view and FIG. 2B is a side view.
FIG. 3 is a plan view showing a first screen used in a first brazing material layer forming step of forming a first brazing material layer.
FIG. 4 is a plan view showing a second screen used in a second brazing material layer forming step of forming a second brazing material layer.
FIG. 5 is a graph showing results of measuring an amount of warpage of the ceramic substrate for various values of a ratio of a thickness of the first brazing material layer to a thickness of the second brazing material layer.

### DETAILED DESCRIPTION OF THE INVENTION

### Embodiment

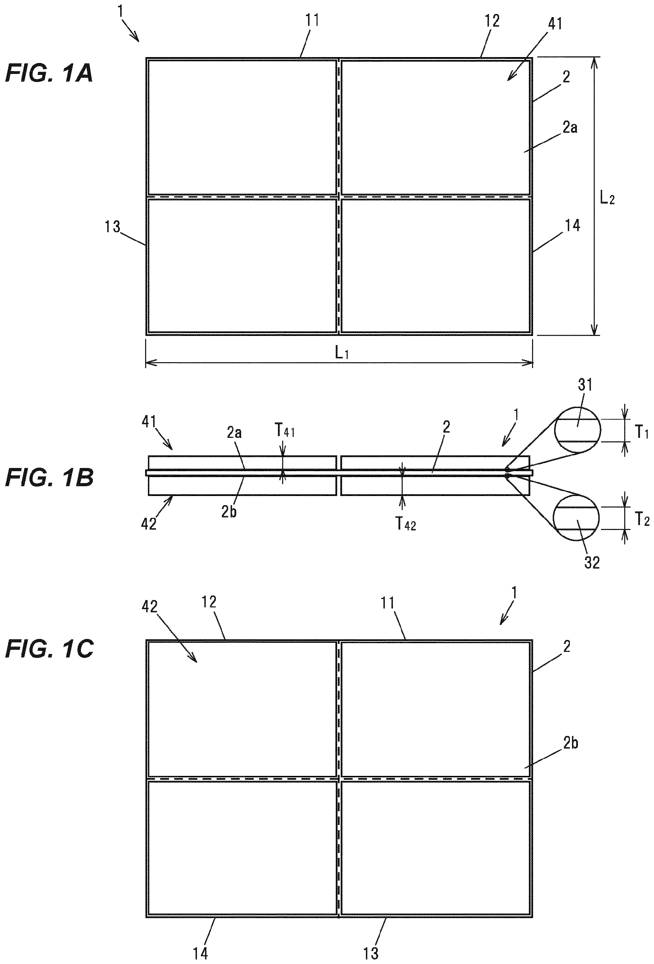

FIGS. 1A to 1C show a configuration example of a ceramic substrate in an embodiment of the invention, wherein FIG. 1A is a plan view showing the front surface, FIG. 1B is a side view, and FIG. 1C is a plan view showing the back surface. This ceramic substrate 1 includes a flat plate-shaped insulating base 2 made of a ceramic, a first brazing material layer 31 provided on a first main surface 2a of the insulating base 2, a second brazing material layer 32 provided on a second main surface 2b of the insulating base 2, a circuit plate (i.e., circuit layer) 41 made of a metal and fixed through the first brazing material layer 31 to the insulating base 2 on a first main surface 2a-side, and a heat dissipation plate (i.e., heat dissipation layer) 42 made of a metal and fixed through the second brazing material layer 32 to the insulating base 2 on a second main surface 2b-side.

In present embodiment, the ceramic substrate 1 is a collective substrate (i.e., integrated substrate), more specifically, a ceramic collective circuit board. The ceramic substrate 1 is diced along dashed lines shown in FIGS. 1A and 1C and divided into plural ceramic divided substrates (i.e., ceramic diced substrate) 11 to 14. On each of the plural ceramic divided substrates 11 to 14, electrical circuit components are mounted on the circuit plate 41 and a heat dissipation component is attached to the heat dissipation plate 42. Although the ceramic substrate 1 is divided into the four ceramic divided substrates 11 to 14 in the present embodiment, the number of the divided pieces of the ceramic substrate is not limited four and may be two, three, or not less than five.

Metal materials used to form the circuit plate 41 and the heat dissipation plate 42 desirably have low electrical resistance and high thermal conductivity. Although the circuit plate 41 and the heat dissipation plate 42 are composed of copper sheets in the present embodiment, the circuit plate 41 and the heat dissipation plate 42 may be aluminum sheets. In this regard, however, to prevent warpage due to a difference in coefficient of thermal expansion, the circuit plate 41 and the heat dissipation plate 42 are desirably made of the same type of metal. The heat dissipation plate 42 is formed in a rectangular shape in plan view and transfers heat generated by the electrical circuit components mounted on the circuit plate 41, from the insulating base 2 to the heat dissipation component.

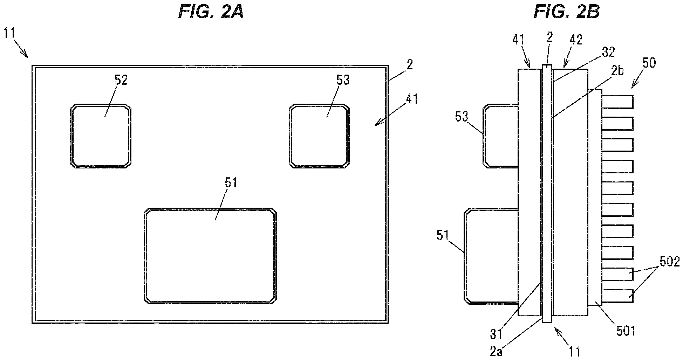

FIGS. 2A to 2B show a state in which first to third electrical circuit components 51 to 53 are mounted on the front side of one ceramic divided substrate 11 and a heat sink 50 as the heat dissipation component is attached on the back side, wherein FIG. 2A is a plan view showing the front surface and FIG. 2B is a side view.

The first to third electrical circuit components 51 to 53 are, e.g., power modules, such as transistor or diode, which are heat-generating components. The heat sink 50 has a base plate 501 having a flat plate shape and plural protruding pieces 502 protruding from the base plate 501, and dissipates heat generated by the first to third electrical circuit components 51 to 53 and conducted from the insulating base 2 to the heat dissipation plate 42, into the air. The number of electrical circuit components mounted on each of the ceramic divided substrates 11 to 14 can be not less than one and is not specifically limited. The type, shape, and quantity, etc., of the electric circuit components mounted on the ceramic divided substrates 11 to 14 are not limited to those shown in FIGS. 2A to 2B and can be appropriately changed.

As an example, the insulating base 2 is a silicon nitride substrate which is formed as follows: a slurry as a mixture of silicon powder, a sintering aid and an organic binder is formed in a flat plate shape with a uniform thickness by the doctor blade method, is then diced, subjected to degreasing treatment and nitriding treatment, and further sintered. In the example shown in FIGS. 1A to 1C, the insulating base 2 has a rectangular shape in plan view, where a length L1 in a long-side direction is larger than a length L2 in a short-side direction. L1 and L2 are both not less than 100 mm. Four corners of the insulating base 2 may be chamfered. When the raw material of the insulating base 2 is silicon nitride powder instead of silicon powder, the nitriding treatment may be omitted.

The first brazing material layer 31 and the second brazing material layer 32 are formed by applying a brazing material, which is obtained by mixing copper powder and silver powder together with a binder and a solvent, to the first main surface 2a and the second main surface 2b of the insulating base 2 using the screen printing method. The first brazing material layer 31 is formed on the entire surface of the circuit plate 41 on an insulating base 2-side, and the second brazing material layer 32 is formed on the entire surface of the heat dissipation plate 42 on the insulating base 2-side. The first brazing material layer 31 and the second brazing material layer 32 may be layers absent of silver powder.

In the present embodiment, a thickness T42 of the heat dissipation plate 42 is larger than a thickness T41 of the circuit plate 41. In addition, a thickness T1 of the first brazing material layer 31 is larger than a thickness T2 of the second brazing material layer 32. The reason why the thickness T42 of the heat dissipation plate 42 is larger than the thickness T41 of the circuit plate 41 is to enhance heat dissipation of the ceramic substrate 1. The reason why the thickness T1 of the first brazing material layer 31 is larger than the thickness T2 of the second brazing material layer 32 is to suppress warpage of the ceramic substrate 1.

That is, the present inventors confirmed that when the thickness T1 of the first brazing material layer 31 is the same as the thickness T2 of the second brazing material layer 32, making the heat dissipation plate 42 thicker than the circuit plate 41 causes the ceramic substrate 1 to warp with a convex at a center portion of the insulating base 2 on the first main surface 2a-side, hence, the thickness T1 of the first brazing material layer 31 is larger than the thickness T2 of the second brazing material layer 32 in the present embodiment to suppress the warpage. That is, in the present embodiment, a force generated by a difference between the thickness T42 of the heat dissipation plate 42 and the thickness T41 of the circuit plate 41 and causing warpage of the ceramic substrate 1 is reduced by increasing the thickness T1 of the first brazing material layer 31 to more than the thickness T2 of the second brazing material layer 32. In the present embodiment, the amount of warpage of the insulating base 2 per 100 mm in a direction along each side of the insulating base 2 is 1.0 mm or less.

The difference between the thickness T41 of the circuit plate 41 and the thickness T42 of the heat dissipation plate 42 is 0.10 mm or more and 0.30 mm or less, and may be 0.20 mm or more and 0.30 mm or less. A desirable range of a difference between the thickness T1 of the first brazing material layer 31 and the thickness T2 of the second brazing material layer 32 is 10 µm or more and 50 µm or less. As an example, the thickness T41 of the circuit plate 41 is 0.5 mm or more and 1.2 mm or less, and the thickness T42 of the heat dissipation plate 42 is 0.6 mm or more and 1.5 mm or less. In addition, the thickness T1 of the first brazing material layer 31 is 20 µm or more and 70 µm or less, and the thickness T2 of the second brazing material layer 32 is 10 µm or more and 30 µm or less.

When the thickness of the first brazing material layer 31 is too large, a portion of the brazing material may stick out from between the circuit plate 41 and the insulating base 2. When the thickness of the second brazing material layer 32 is too small, voids (pores) may occur, causing a decrease in strength of the second brazing material layer 32 and a decrease in thermal conductivity of the second brazing material layer 32. The ranges of the thickness T1 of the first brazing material layer 31 and the thickness T2 of the second brazing material layer 32 mentioned above were examined in consideration of these factors.

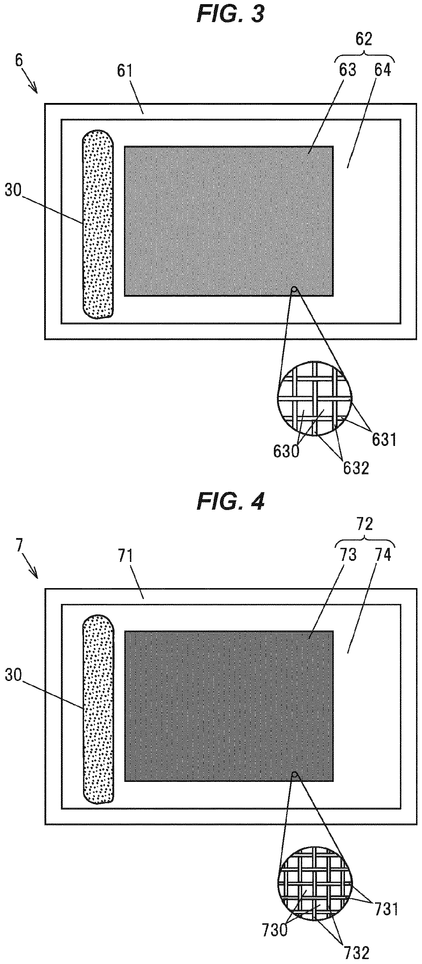

The thickness T1 of the first brazing material layer 31 and the thickness T2 of the second brazing material layer 32 can be increased or decreased by changing a screen used for screen printing of the brazing material during manufacturing of the ceramic substrate 1. Next, a configuration example of this screen will be described in reference to FIGS. 3 and 4.

FIG. 3 is a plan view showing a first screen 6 used in a first brazing material layer forming step of forming the first brazing material layer 31. FIG. 4 is a plan view showing a second screen 7 used in a second brazing material layer forming step of forming the second brazing material layer 32. The first and second screens 6 and 7 respectively have frames 61, 71, and flat plate-shaped screen masks 62, 72. The screen masks 62, 72 respectively have mesh portions 63, 73 allowing a brazing material 30 in the form of paste to pass through, and non-mesh portions 64, 74 not allowing the brazing material 30 to pass through.

The mesh portions 63, 73 are respectively composed of plural warp threads 631, 731 stretched parallel to the long-side direction of the insulating base 2 and plural weft threads 632, 732 stretched parallel to the short-side direction of the insulating base 2, which are woven together in a grid pattern, and an areas surrounded by two warp threads 631 or 731 and two weft threads 632 or 732 is a permeation hole 630 or 730. At the time of screen printing, a long plate-shaped member called "squeegee" slides on the mesh portions 63, 73 while contacting the plural warp threads 631, 731 and the plural weft threads 632, 732 and pushes the brazing material 30 out through the permeation holes 630, 730 toward the insulating base 2-side.

The thickness T1 of the first brazing material layer 31 and the thickness T2 of the second brazing material layer 32 vary depending on the amount of the brazing material 30 pushed out toward the insulating base 2-side. In the present embodiment, the warp threads 631 and the weft threads 632 of the first screen 6 are thicker than the warp threads 731 and the weft threads 732 of the second screen 7, the spacing of the warp threads 631 and the weft threads 632 of the first screen 6 is wider than the spacing of the warp threads 731 and the weft threads 732 of the second screen 7, and the volume of the plural permeation holes 630 of the first screen 6 per unit area is larger than the volume of the plural permeation holes 730 of the second screen 7 per unit area. As a result, the first brazing material layer 31 is formed thicker than the second brazing material layer 32.

In this regard, the volume of the plural permeation holes 630 of the first screen 6 per unit area is determined by the spacing and thickness of the plural warp threads 631 and the plural weft threads 632, and is larger when the spacing of the plural warp threads 631 and the plural weft threads 632 of the first screen 6 is wider and the opening width of the permeation holes 630 in a direction parallel to the warp threads 631 and in a direction parallel to the weft threads 632 is larger. Likewise, the volume of the plural permeation holes 730 of the second screen 7 per unit area is determined by the spacing and thickness of the plural warp threads 731 and the plural weft threads 732, and is larger when the spacing of the plural warp threads 731 and the plural weft threads 732 of the second screen 7 is wider and the opening width of the permeation holes 730 in a direction parallel to the warp threads 731 and in a direction parallel to the weft threads 732 is larger. Therefore, the volumes of the permeation holes 630, 730 per unit area can be adjusted by the thicknesses of the warp threads 631, 731 and the weft threads, 632, 732 and the numbers of the warp threads 631, 731 and the weft threads, 632, 732 per unit area.

The brazing material applied to the first main surface 2a and the second main surface 2b of the insulating base 2 by screen printing is solidified by drying in a constant temperature oven. After that, brazing is performed by heating to about 800°C in a state in which a load is applied to the two metal sheets with the insulating base 2 and the brazing material sandwiched therebetween. After that, a portion of each of these metal sheets is removed by etching, thereby forming the circuit plate 41 and the heat dissipation plate 42. The ceramic substrate 1 is thereby obtained. By subsequently dicing the ceramic substrate 1 along dashed lines shown in FIGS. 1A and 1C, the plural ceramic divided substrates 11 to 14 are obtained. In this regard, the etching may be omitted by processing the circuit plate 41 and the heat dissipation plate 42 into predetermined shapes in advance.

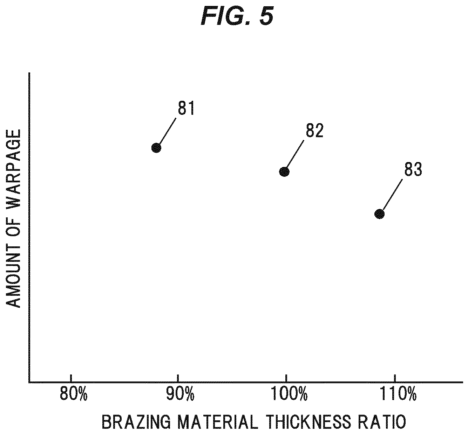

FIG. 5 is a graph showing results of measuring an amount of warpage of the ceramic substrate 1 having the circuit plate 41 with the thickness T41 of 0.65 mm and the heat dissipation plate 42 with the thickness T42 of 0.80 mm, for three different values of a brazing material thickness ratio (T1/T2) which is a ratio of the thickness T1 of the first brazing material layer 31 to the thickness T2 of the second brazing material layer 32. In this graph, a first plotted point 81 indicates the measurement result of Sample 1 with the brazing material thickness ratio of 88%, a second plotted point 82 indicates the measurement result of Sample 2 with the brazing material thickness ratio of 100%, and a third plotted point 83 indicates the measurement result of Sample 3 with brazing material thickness ratio of 109%. The brazing material thickness ratio is an estimated value based on a weight difference before and after performing screen printing of the brazing material in the first brazing material layer forming step and the second brazing material layer forming step. This graph shows that the amount of warpage of the ceramic substrate 1 can be reduced by increasing the ratio of the thickness T1 of the first brazing material layer 31 to the thickness T2 of the second brazing material layer 32.

In the embodiment described above, it was shown that when the thickness of the heat dissipation plate is larger than the thickness of the circuit plate, the amount of warpage of the ceramic substrate can be reduced by making the first brazing material layer thicker than the second brazing material layer. Similarly, when the thickness of the circuit plate is larger than the thickness of the heat dissipation plate, the amount of warpage of the ceramic substrate can be reduced by making the second brazing material layer thicker than the first brazing material layer. For example, it can be configured such that the thickness of the circuit plate is 0.8 mm, the thickness of the heat dissipating plate is 0.65 mm, the thickness of the first brazing material layer is 15 µm, and the thickness of the second brazing material layer is 30 µm. In addition, in such a case, it is preferable that the thickness of the circuit plate be 0.6 mm to 1.5 mm, the thickness of the heat dissipation plate be 0.5 mm to 1.2 mm, the thickness of the first brazing material layer be 10 µm to 30 µm, and the thickness of the second brazing material layer be 20 µm to 30 µm.

That is, even when one of the heat dissipation plate and the circuit plate is thicker than the other, the amount of warpage of the ceramic substrate can be reduced by adjusting the thicknesses of the first brazing material layer and the second brazing material layer.

### Functions and effects of the embodiment

According to the embodiment described above, it is possible to suppress warpage of the ceramic substrate 1 even when one of the heat dissipation plate 42 and the circuit plate 41 is thicker than the other.

### Summary of the embodiment

Technical ideas understood from the embodiment will be described below citing the reference signs, etc., used for the embodiment. However, each reference sign, etc., described below is not intended to limit the constituent elements in the claims to the members, etc., specifically described in the embodiment.

According to the first feature, a ceramic substrate 1 includes a flat plate-shaped insulating base 2 including a ceramic; a first brazing material layer 31 provided on a first main surface 2a of the insulating base 2; a second brazing material layer 32 provided on a second main surface 2b of the insulating base 2; a circuit plate 41 including a metal and being fixed through the first brazing material layer 31 to the insulating base 2 on a first main surface 2a-side; and a heat dissipation plate 42 including a metal and being fixed through the second brazing material layer 32 to the insulating base 2 on a second main surface 2b-side; wherein a thickness of one of the heat dissipation plate 42 and the circuit plate 41 is larger than a thickness of the other, wherein when the thickness of the heat dissipation plate 42 is larger than the thickness of the circuit plate 41, a thickness of the first brazing material layer 31 is larger than a thickness of the second brazing material layer 32, and wherein when the thickness of the circuit plate 41 is larger than the thickness of the heat dissipation plate 42, the thickness of the second brazing material layer 32 is larger than the thickness of the first brazing material layer 31.

According to the second feature, in the ceramic substrate 1 as described by the first feature, a difference in thickness between the circuit plate 41 and the heat dissipation plate 42 is 0.10 mm or more and 0.30 mm or less.

According to the third feature, in the ceramic substrate 1 as described by the first, a difference in thickness between the circuit plate 41 and the heat dissipation plate 42 is 0.20 mm or more and 0.30 mm or less.

According to the fourth feature, in the ceramic substrate 1 as described by the first or second feature, a difference between the thickness T1 of the first brazing material layer 31 and the thickness T2 of the second brazing material layer 32 is 10 µm or more and 50 µm or less.

According to the fifth feature, in the ceramic substrate 1 as described by any one of the first to fourth features, the thickness T41 of the circuit plate 41 is 0.5 mm or more and 1.2 mm or less, wherein the thickness T42 of the heat dissipation plate 42 is 0.6 mm or more and 1.5 mm or less, wherein the thickness T1 of the first brazing material layer 31 is 20 µm or more and 70 µm or less, and wherein the thickness T2 of the second brazing material layer 32 is 10 µm or more and 30 µm or less.

According to the sixth feature, in the ceramic substrate 1 as described by any one of the first to fifth features, the insulating base 2 has a rectangular shape, and wherein an amount of warpage of the insulating base 2 per 100 mm in a direction along each side of the insulating base 2 is 1.0 mm or less.

According to the seventh feature, in a ceramic divided substrate 11 that is formed by dividing the ceramic substrate 1 defined by any one of the first to sixth features into a plurality of pieces.

## Claims

1. A ceramic substrate, comprising:
a flat plate-shaped insulating base comprising a ceramic;
a first brazing material layer provided on a first main surface of the insulating base;
a second brazing material layer provided on a second main surface of the insulating base;
a circuit plate comprising a metal and being fixed through the first brazing material layer to the insulating base on a first main surface-side; and
a heat dissipation plate comprising a metal and being fixed through the second brazing material layer to the insulating base on a second main surface-side,
wherein a thickness of one of the heat dissipation plate and the circuit plate is larger than a thickness of the other,
wherein when the thickness of the heat dissipation plate is larger than the thickness of the circuit plate, a thickness of the first brazing material layer is larger than a thickness of the second brazing material layer, and
wherein when the thickness of the circuit plate is larger than the thickness of the heat dissipation plate, the thickness of the second brazing material layer is larger than the thickness of the first brazing material layer.

2. The ceramic substrate according to claim 1, wherein a difference in thickness between the circuit plate and the heat dissipation plate is 0.10 mm or more and 0.30 mm or less.

3. The ceramic substrate according to claim 1, wherein a difference in thickness between the circuit plate and the heat dissipation plate is 0.20 mm or more and 0.30 mm or less.

4. The ceramic substrate according to claim 1 or 2, wherein a difference between the thickness of the first brazing material layer and the thickness of the second brazing material layer is 10 µm or more and 50 µm or less.

5. The ceramic substrate according to any one of claims 1 to 3, wherein the thickness of the circuit plate is 0.5 mm or more and 1.2 mm or less, wherein the thickness of the heat dissipation plate is 0.6 mm or more and 1.5 mm or less, wherein the thickness of the first brazing material layer is 20 µm or more and 70 µm or less, and wherein the thickness of the second brazing material layer is 10 µm or more and 30 µm or less.

6. The ceramic substrate according to any one of claims 1 to 3, wherein the insulating base has a rectangular shape, and wherein, by the thickness of the first brazing material layer being higher than the thickness of the second brazing material layer, an amount of warpage of the insulating base per 100 mm in a direction along each side of the insulating base is 1.0 mm or less.

7. A ceramic divided substrate that is formed by dividing the ceramic substrate according to any one of claims 1 to 3 into a plurality of pieces.

## Patentansprüche

1. Keramisches Substrat, umfassend:
eine flache, plattenförmige, isolierende Basis, umfassend eine Keramik;
eine erste Hartlotschicht, die auf einer ersten Hauptfläche der isolierenden Basis bereitgestellt ist;
eine zweite Hartlotschicht, die auf einer zweiten Hauptfläche der isolierenden Basis bereitgestellt ist;
eine Schaltungsplatte, die ein Metall umfasst und durch die erste Hartlotschicht an der isolierenden Basis auf einer ersten Hauptflächenseite befestigt ist; und
eine Wärmeableitungsplatte, die ein Metall umfasst und durch die zweite Hartlotschicht an der isolierenden Basis auf einer zweiten Hauptflächenseite befestigt ist,
wobei eine Dicke von einer der Wärmeableitungsplatte und der Schaltungsplatte größer ist als eine Dicke der anderen,
wobei, wenn die Dicke der Wärmeableitungsplatte größer als die Dicke der Schaltungsplatte ist, eine Dicke der ersten Hartlotschicht größer als eine Dicke der zweiten Hartlotschicht ist, und
wobei, wenn die Dicke der Schaltungsplatte größer als die Dicke der Wärmeableitungsplatte ist, die Dicke der zweiten Hartlotschicht größer als die Dicke der ersten Hartlotschicht ist.

2. Keramisches Substrat nach Anspruch 1, wobei ein Unterschied in der Dicke zwischen der Schaltungsplatte und der Wärmeableitungsplatte 0,10 mm oder mehr und 0,30 mm oder weniger beträgt.

3. Keramisches Substrat nach Anspruch 1, wobei ein Unterschied in der Dicke zwischen der Schaltungsplatte und der Wärmeableitungsplatte 0,20 mm oder mehr und 0,30 mm oder weniger beträgt.

4. Das Keramiksubstrat gemäß Anspruch 1 oder 2, wobei der Unterschied zwischen der Dicke der ersten Hartlotschicht und der Dicke der zweiten Hartlotschicht 10 µm oder mehr und 50 µm oder weniger beträgt.

5. Keramisches Substrat gemäß einem der Ansprüche 1 bis 3, wobei die Dicke der Schaltungsplatte 0,5 mm oder mehr und 1,2 mm oder weniger beträgt, wobei die Dicke der Wärmeableitungsplatte 0,6 mm oder mehr und 1, 5 mm oder weniger beträgt, wobei die Dicke der ersten Hartlotschicht 20 µm oder mehr und 70 µm oder weniger beträgt und wobei die Dicke der zweiten Hartlotschicht 10 µm oder mehr und 30 µm oder weniger beträgt.

6. Keramisches Substrat nach einem der Ansprüche 1 bis 3, wobei die isolierende Basis eine rechteckige Form aufweist und wobei durch die Dicke der ersten Hartlotschicht, die größer ist als die Dicke der zweiten Hartlotschicht, ein Ausmaß an Verformung der isolierenden Basis pro 100 mm in einer Richtung entlang jeder Seite der isolierenden Basis 1,0 mm oder weniger beträgt.

7. Ein keramisches geteiltes Substrat, das durch Teilen des keramischen Substrats gemäß einem der Ansprüche 1 bis 3 in eine Vielzahl von Stücken gebildet wird.

## Revendications

1. Un substrat en céramique, comprenant :
une base isolante en forme de plaque plate comprenant une céramique ;
une première couche de matériau de brasure se trouvant sur une première surface principale de la base isolante ;
une deuxième couche de matériau de brasure se trouvant sur une deuxième surface principale de la base isolante ;
une plaque de circuit comprenant un métal et fixée par l'intermédiaire de la première couche de matériau de brasure à la base isolante sur le côté première surface principale ; et
une plaque de dissipation de chaleur comprenant un métal et étant fixée par l'intermédiaire de la deuxième couche de matériau de brasure à la base isolante sur le côté deuxième surface principale,
une épaisseur de l'une parmi la plaque de dissipation de chaleur et la plaque de circuit étant supérieure à une épaisseur de l'autre,
une épaisseur de la première couche de matériau de brasure étant, lorsque l'épaisseur de la plaque de dissipation de chaleur est supérieure à l'épaisseur de la plaque de circuit, supérieure à une épaisseur de la deuxième couche de matériau de brasure, et
l'épaisseur de la deuxième couche de matériau de brasure étant, lorsque l'épaisseur de la plaque de circuit est supérieure à l'épaisseur de la plaque de dissipation de chaleur, supérieure à l'épaisseur de la première couche de matériau de brasure.

2. Le substrat en céramique selon la revendication 1, dans lequel la différence d'épaisseur entre la plaque de circuit et la plaque de dissipation de chaleur est de 0,10 mm ou plus et de 0,30 mm ou moins.

3. Le substrat en céramique selon la revendication 1, dans lequel la différence d'épaisseur entre la plaque de circuit et la plaque de dissipation de chaleur est de 0,20 mm ou plus et de 0,30 mm ou moins.

4. Le substrat en céramique selon la revendication 1 ou la revendication 2, dans lequel la différence entre l'épaisseur de la première couche de matériau de brasure et l'épaisseur de la deuxième couche de matériau de brasure est de 10 µm ou plus et de 50 µm ou moins.

5. Le substrat en céramique selon l'une quelconque des revendications 1 à 3, dans lequel l'épaisseur de la plaque de circuit est de 0,5 mm ou plus et de 1,2 mm ou moins, l'épaisseur de la plaque de dissipation de chaleur est de 0,6 mm ou plus et de 1,5 mm ou moins, l'épaisseur de la première couche de matériau de brasure est de 20 µm ou plus et de 70 µm ou moins, et l'épaisseur de la deuxième couche de matériau de brasure est de 10 µm ou plus et de 30 µm ou moins.

6. Le substrat en céramique selon l'une quelconque des revendications 1 à 3, dans lequel la base isolante a une forme rectangulaire, et dans lequel, du fait que l'épaisseur de la première couche de matériau de brasure est supérieure à l'épaisseur de la deuxième couche de matériau de brasure, une quantité de gauchissement de la base isolante par 100 mm dans une direction le long de chaque côté de la base isolante est de 1,0 mm ou moins.

7. Un substrat en céramique divisé qui est formé en divisant le substrat en céramique selon l'une quelconque des revendications 1 à 3 en une pluralité de pièces.
